# DEMANDE DE BREVET EUROPEEN

(11) **EP 3 474 356 A1**
(43) Date de publication de la demande: **24.04.2019**
(21) Numéro de dépôt: 18200326.9
(22) Date de dépôt: 15.10.2018
(51) Int. Cl.: H01M 4/86, H01M 4/88, H01M 4/96, H01M 8/0234, H01M 8/0245, H01M 8/0247, B82Y 30/00, B82Y 40/00, C01B 32/162, C23C 16/02, C23C 16/26, H01M 8/1018

(54) **STRUCTURE MULTICOUCHE INTÉGRANT UN TAPIS DE NANOTUBES DE CARBONE COMME COUCHE DE DIFFUSION DANS UNE PEMFC**

(30) Priorité: 20.10.2017 FR 1759881
(71) Demandeur: Commissariat à l'Energie Atomique et aux Energies Alternatives, 75015 Paris (FR)
(72) Inventeur: MORIN, Arnaud, 38700 CORENC (FR); DIJON, Jean, 38800 CHAMPAGNIER (FR); RAMOS, Raphael, 38100 GRENOBLE (FR)
(74) Mandataire: Nony

(57) **Abrégé**

La présente invention concerne une structure multicouche (10), utile comme couche de diffusion composite dans une pile à combustible à membrane échangeuse de protons (PEMFC), comportant au moins un tapis de nanotubes de carbone (NTC) (1) de diamètre unitaire inférieur ou égal à 20 nm, définissant au moins une face de ladite structure, ledit tapis de nanotubes de carbone (1) étant superposé à un support à base de fibres de carbone.

Elle se rapporte encore à un procédé de préparation d'une telle structure multicouche, et à son utilisation pour une électrode d'une PEMFC.

## Description

La présente invention concerne le domaine des piles à combustible à membrane échangeuse de protons. Elle se rapporte plus précisément à l'utilisation d'une nouvelle structure multicouche comme couche de diffusion dans une pile combustible à membrane échangeuse de protons, permettant de conduire à des performances significativement améliorées.

La pile à combustible à membrane échangeuse de protons (notée PEMFC selon l'acronyme anglais « Proton Exchange Membrane Fuel Cell ») est un dispositif de conversion électrochimique de l'énergie considéré comme une source d'énergie prometteuse pour les applications transport. Bien que cette technologie ait été à l'avant-garde des efforts de commercialisation au cours des deux dernières décennies, surtout par les constructeurs automobiles, des percées sont encore nécessaires pour satisfaire toutes les spécifications de coût et de durabilité.

Le principe de fonctionnement d'une pile PEMFC repose sur la conversion de l'énergie chimique en énergie électrique par réaction catalytique de l'hydrogène et de l'oxygène. Une pile comprend au moins une cellule, mais plus généralement un empilement en série de plusieurs cellules, pour répondre aux besoins des applications. Chaque cellule comprend un assemblage membrane-électrodes, appelé communément coeur de pile qui constitue l'élément de base des PEMFC.

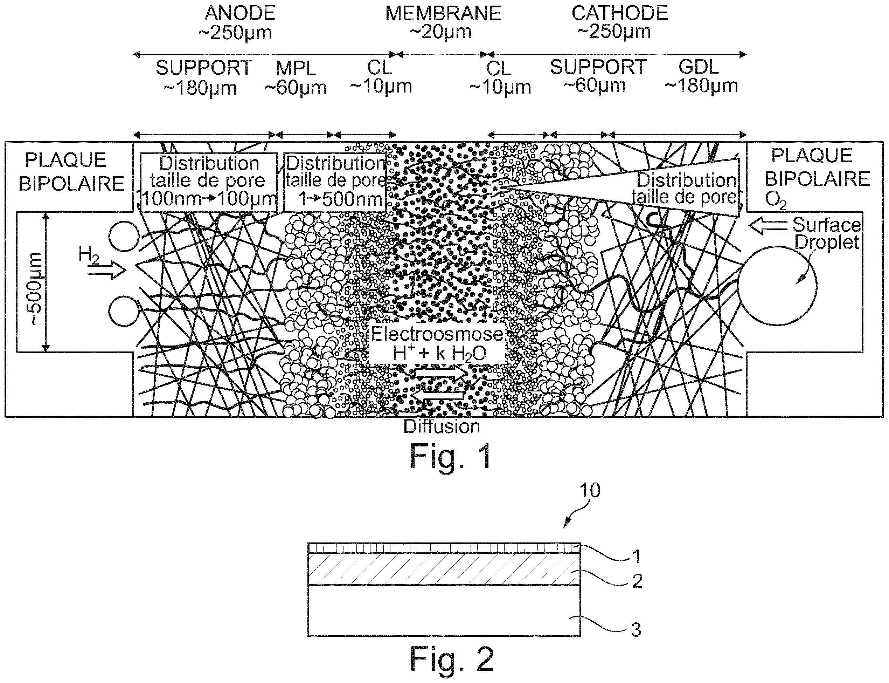

Dans le coeur de pile, comme représenté schématiquement en figure 1, se déroule l'ensemble des phénomènes donnant lieu à la conversion d'énergie. Comme dans tout système électrochimique, il est constitué de deux électrodes, une anode et une cathode, séparées par un électrolyte. Dans le cas de la PEMFC, ce dernier est une membrane polymère d'une épaisseur comprise entre 10 et 20 µm. Les électrodes sont formées de deux parties principales : une couche active (ou CL pour « catalyst layer » en langue anglaise), lieu des réactions électrochimiques catalysées par le platine (5 à 15 µm d'épaisseur), et une couche de diffusion (GDL pour « Gas Diffusion Layer » en langue anglaise), d'une épaisseur comprise entre 150 et 300 µm.

Cette couche de diffusion a un impact significatif à la fois sur les performances et sur la durabilité de la PEMFC, en raison de son rôle sur l'ensemble des phénomènes de transport intervenant au sein du coeur de la pile. Ainsi, la couche de diffusion sert à la collecte du courant, à l'alimentation en gaz réactif, mais aussi à l'élimination de l'eau et de la chaleur produites au sein du coeur de pile. Pour répondre à l'ensemble de ces exigences, elle doit donc présenter des caractéristiques antagonistes, en alliant simultanément des bonnes propriétés de transport, d'une part, des électrons et de la chaleur et, d'autre part, de l'eau liquide et des gaz. Les couches de diffusion présentent généralement deux couches permettant d'atteindre des résultats optimaux : une couche dite microporeuse (MPL pour « Micro-Porous Layer »), typiquement d'épaisseur comprise entre 20 et 80 µm, déposée sur un substrat à base de fibres de carbone. Différentes études ([1], [2]) ont mis en évidence le rôle de cette couche microporeuse pour modifier la répartition d'eau entre l'anode et la cathode. La couche microporeuse semble à la fois empêcher l'assèchement du polymère conducteur protonique en conditions sèches et le noyage des couches actives en conditions très humides. Même si elle progresse, la compréhension des relations structure/propriétés, et propriétés/performances de la couche de diffusion est encore partielle et reste très qualitative.

L'amélioration des performances des PEMFC passe ainsi notamment par la possibilité d'élaborer des alternatives aux couches de diffusion actuellement disponibles.

La présente invention vise précisément à proposer de nouvelles structures de couche de diffusion, répondant aux exigences précitées et permettant d'améliorer les performances des PEMFC dont l'une au moins des électrodes intègre une telle couche de diffusion.

Plus précisément, les inventeurs ont constaté que la mise en oeuvre d'une structure orientée et dense de nanotubes de carbone de diamètre moyen unitaire inférieur à 20 nm, à l'interface avec la couche active d'une électrode dans une PEMFC, permet d'accroitre, de manière significative, les performances de la pile, comparativement à celles obtenues avec des structures conventionnelles de couche de diffusion.

La présente invention concerne ainsi, selon un premier de ses aspects, une structure multicouche, utile comme couche de diffusion composite dans une pile à combustible à membrane échangeuse de protons, comportant au moins un tapis de nanotubes de carbone de diamètre unitaire moyen inférieur ou égal à 20 nm, définissant au moins une face de ladite structure multicouche, ledit tapis de nanotubes de carbone étant superposé à un support à base de fibres de carbone.

Par « tapis de nanotubes », on entend désigner au sens de l'invention une couche de nanotubes de carbone, sensiblement parallèles entre eux, orientés perpendiculairement au support à base de fibres de carbone, et dont l'épaisseur est proche de la longueur unitaire des nanotubes.

Un tapis selon l'invention de nanotubes de carbone, notés « NTC » dans la suite du texte, présente plus particulièrement une densité élevée en nanotubes de carbone, en particulier une densité supérieure ou égale à 10¹¹ nanotubes par cm² et plus particulièrement comprise entre 10¹¹ et 10¹³ nanotubes par cm².

Les publications Tang *et al.* [3] et Xie *et al.* [4] décrivent déjà la croissance de nanotubes de carbone sur des fibres de carbone. Plus particulièrement, Tang *et al.* décrivent la croissance d'une couche de nanotubes de carbone par dépôt chimique en phase vapeur (CVD pour « Chemical Vapor Deposition ») en surface d'un papier en carbone, en mettant en oeuvre une fine couche de fer à titre de catalyseur de croissance des NTC. Il est proposé de tirer profit de la porosité élevée de la couche de nanotubes de carbone formée pour fournir une surface spécifique élevée au catalyseur à base de platine dans une électrode d'une PEMFC, et mettre en oeuvre une telle couche à la fois comme couche de diffusion (GDL) et comme couche active (CL). Quant à Xie *et al.,* ils proposent de faire croître par dépôt chimique en phase vapeur assisté par plasma (PECVD pour « Plasma-Enhanced Chemical Vapor Deposition ») des nanotubes de carbone à partir d'un catalyseur à base de nickel sur les fibres de carbone d'une couche de diffusion.

Dans ces deux études, les nanotubes de carbone ne sont toutefois nullement organisés sous forme de tapis dense de nanotubes orientés et, d'autre part, présentent un diamètre unitaire moyen supérieur à 50 nm. D'autre part, les performances obtenues à l'aide des couches de nanotubes décrites dans ces publications restent inférieures à celles obtenues avec des structures conventionnelles de couche de diffusion formée à partir d'une couche microporeuse à base de noir de carbone, graphène ou graphite.

L'expression « tapis de NTC superposé au support » entend signifier que la couche de NTC est présente sur tout ou partie de la surface du support à base de fibres de carbone, et n'implique pas nécessairement de contact direct entre ladite couche de NTC et le support sous-jacent. Autrement dit, pour une direction verticale d'empilement de la structure multicouche selon l'invention, le contour du tapis de NTC rentre entièrement dans l'élévation verticale du contour du support carboné sous-jacent.

Comme détaillé dans la suite du texte, le support à base de fibres de carbone sert plus particulièrement de base pour la croissance des NTC, à partir du dépôt d'un empilement catalytique de couches minces à la surface du support de base.

Plus généralement, dans la suite du texte et sauf indication contraires, les termes « superposé », « porté » ou « supporté » sont utilisés indifféremment pour caractériser la position d'une couche (substrat ou support) par rapport à une autre couche (substrat ou support) et n'imposent pas que la première couche (substrat ou support) et la seconde couche (substrat ou support) soient jointives, c'est-à-dire en contact direct, l'une de l'autre.

Un tapis de NTC selon l'invention peut notamment être obtenu par voie catalytique par une méthode de croissance de NTC dite « base-growth » (par distinction avec un mode de croissance « tip-growth »), comme décrit dans la publication [5] au chapitre 8 « Carbon Nanotube Synthesis and Growth Mechanism », sous-chapitre 3 « CNT growth mechanism », en mettant en oeuvre en surface du support, préalablement à la croissance des NTC, un empilement de couches minces spécifiques, comprenant au moins un catalyseur de croissance des NTC.

Cet empilement comprend plus particulièrement la séquence de couches minces dans l'ordre suivant, depuis la face du support carboné destinée à supporter le tapis de NTC, jusqu'au tapis de NTC :
a/ éventuellement, une couche métallique en métal M ou une couche en alliage métallique à base du métal M ou une couche en graphène ;
b/ une couche de titane (Ti) ;
c/ une couche d'aluminium (Al) ;
d/ une couche de matériau(x) catalyseur(s) de la croissance de nanotubes de carbone.

L'interface entre le support à base de fibres de carbone et le tapis de NTC qui lui est superposé selon l'invention comprend ainsi, en particulier est formée, d'un tel empilement de couches minces.

Cette méthode de croissance catalytique de NTC à l'aide d'un tel empilement multicouche a déjà été proposée dans le document WO 2014/191915 pour former des tapis de NTC denses sur des substrats métalliques ou revêtus de graphène, en vue d'augmenter la conductivité électrique, avantageusement thermique entre ces tapis de NTC et lesdites faces conductrices des substrats.

En revanche, à la connaissance des inventeurs, il n'a jamais été proposé de mettre en oeuvre cette méthode de croissance des NTC pour former un tapis de NTC sur des fibres de carbone, et encore moins de tirer profit du tapis de NTC ainsi formé dans une couche composite de diffusion d'une pile à combustible à membrane échangeuse de protons.

Ainsi, selon un autre de ses aspects, l'invention concerne un procédé de préparation d'une structure multicouche, utile comme couche de diffusion composite dans une pile à combustible à membrane échangeuse de protons (PEMFC), comprenant au moins les étapes suivantes :
(i) réalisation sur au moins l'une des faces d'un support à base de fibres de carbone, comprenant moins de 30 % massique d'agent(s) hydrophobe(s), en particulier moins de 10 % massique et de préférence étant dépourvu d'agent hydrophobe, d'un empilement catalytique de couches minces tel que décrit précédemment ; et
(ii) croissance d'un tapis de nanotubes de carbone sur l'empilement selon une technique de dépôt chimique en phase vapeur, assistée ou non par plasma, et activée par filaments chauds ou non.

Comme illustré dans les exemples qui suivent, la mise en oeuvre d'une telle structure multicouche selon l'invention comme couche de diffusion composite au niveau d'une électrode d'une PEMFC, avec ledit tapis de NTC positionné en contact avec la couche active (également appelée couche catalytique) de l'électrode, autrement dit, en lieu et place de la couche microporeuse (typiquement à base de noir de carbone, graphène ou graphite), permet d'améliorer significativement les performances de la pile. Elle permet typiquement de conduire à des rendements de 20 à 50 % supérieurs à ceux obtenus avec une structure classique intégrant une couche microporeuse.

Ainsi, l'invention concerne encore, selon un autre de ses aspects, l'utilisation d'une structure multicouche telle que définie précédemment, à titre de couche de diffusion composite dans une électrode, en particulier de la cathode, d'une PEMFC, au moins un tapis de NTC étant positionné en contact avec la couche active de l'électrode.

Comme détaillé dans la suite du texte, plusieurs variantes de la structure multicouche selon l'invention sont envisageables, notamment au regard de la nature de la PEMFC dans laquelle la structure multicouche est destinée à être mise en oeuvre.

Ainsi, dans le cadre de la mise en oeuvre d'une structure multicouche selon l'invention pour former une couche de diffusion dans une pile à combustible à membrane échangeuse de protons, fonctionnant à haute température (dite encore « PEMFC-HT »), typiquement à des températures allant de 130 à 200 °C, il n'est pas nécessaire que la couche de diffusion possède un traitement hydrophobe. Les piles de type PEMFC-HT se distinguent des PEMFC-LT, fonctionnant à basse température, en particulier, par la nature de leur électrolyte, qui est constitué d'une membrane polymère imprégnée par de l'acide phosphorique. Du fait de leurs conditions de fonctionnement (pression, humidité relative des gaz en entrée de la pile), et en particulier de leur température de fonctionnement, il n'y a pas de présence d'eau liquide au sein des composants du coeur de pile PEMFC-HT en fonctionnement nominal. De l'eau liquide peut éventuellement être présente lors de phases d'arrêt ou de démarrage, mais sa présence peut être évitée par des protocoles connus de l'homme du métier. Dès lors, il n'y pas d'eau liquide dans ce type de pile à combustible lors de leur utilisation, ce qui rend inutile un traitement hydrophobe.

En revanche, dans le cadre de la fabrication d'une pile à combustible à membrane échangeuse de protons, fonctionnant à basse température (dite encore « PEMFC-LT »), typiquement à des températures inférieures ou égales à 120 °C, les couches de diffusion doivent impérativement posséder un traitement hydrophobe, ce dernier étant indispensable pour obtenir un composant adapté à la large gamme de conditions opératoires des PEMFC, notamment à des conditions très humides.

Or, le procédé de croissance des nanotubes de carbone selon l'invention, impliquant des températures élevées, typiquement autour de 500°C, est incompatible avec la plupart des agents hydrophobes généralement utilisés tels que des polymères perfluorés, ces derniers se dégradant à des températures élevées. D'autre part, les techniques classiques d'imprégnation par un polymère hydrophobe ne sont pas envisageables au risque de détruire l'organisation et la nanostructure des nanotubes de carbone.

Il est du mérite des inventeurs d'avoir développé différentes variantes de préparation de structure multicouche selon l'invention apte à être mise en oeuvre comme couche de diffusion pour une PEMFC, en particulier pour une PEMFC-LT, et conciliant la présence d'un tapis de NTC conforme à l'invention avec un traitement hydrophobe.

Plus particulièrement, selon une variante de réalisation, le support à base de fibres de carbone d'une structure multicouche selon l'invention peut comprendre :
- un substrat à base de fibres de carbone, éventuellement hydrophobe, en particulier imprégné par au moins un agent hydrophobe ; et
- au moins une couche à base de fibres de carbone, portée par l'une des faces dudit substrat, comprenant moins de 30 % massique en agent(s) hydrophobe(s), en particulier moins de 10 % massique et de préférence dépourvue d'agent hydrophobe, ladite couche présentant, sur au moins sa face opposée audit substrat, ledit tapis de NTC.

Selon une autre variante de réalisation, le support à base de fibres de carbone d'une structure multicouche selon l'invention peut être formé d'un substrat massif à base de fibres de carbone, présentant sur l'une de ses faces ledit tapis de nanotubes de carbone et présentant, au niveau de sa face opposée à celle supportant le tapis de NTC, des propriétés hydrophobes, en particulier étant imprégné par au moins un agent hydrophobe et/ou dont la face, opposée au tapis de NTC, est hydrophobe ou recouverte d'un film hydrophobe.

D'autres modes de réalisation particulièrement avantageux de structures multicouches selon l'invention, en particulier intégrant au moins deux tapis de NTC selon l'invention, sont exposés dans la suite du texte.

L'invention pourra être mieux comprise à la lecture de la description détaillée qui va suivre, donnée en référence aux dessins annexés sur lesquels :
- la figure 1 illustre, de manière schématique, la structure d'une PEMFC, avec les dimensions classiques de chacune des parties de la PEMFC ;
- les figures 2 à 6 représentent, de manière schématique, dans un plan vertical de coupe, différentes variantes de structure multicouche (10) selon l'invention, comprenant au moins un tapis de nanotubes de carbone (1) conforme à l'invention ;
- les figures 7 et 8 représentent des clichés, obtenus par microscopie électronique à balayage (MEB), des tapis de NTC obtenus en surface des fibres de carbone selon l'exemple 1, à partir d'un empilement catalytique Fe/Ti/Al/Fe (figure 7) et Ti/Al/Fe (figure 8) ;
- la figure 9 représente les courbes puissance-tension, représentatives des performances des PEMFC testées selon l'exemple 3, incorporant différentes couches de diffusion détaillées dans l'exemple 3 au niveau de la cathode.

Il convient de noter que, pour des raisons de clarté, les différents éléments sur les figures 1 à 6 sont représentés en échelle libre, les dimensions réelles des différentes parties n'étant pas respectées.

Par ailleurs, pour des raisons de clarté, l'empilement catalytique d'interface entre un support à base de fibres de carbone et un tapis de NTC n'apparaît pas sur les figures 2 à 6.

Dans la suite du texte, les expressions « compris entre ... et ... », « allant de ... à ... » et « variant de ... à ... » sont équivalentes et entendent signifier que les bornes sont incluses, sauf mention contraire.

Sauf indication contraire, l'expression « comportant un(e) » doit être comprise comme « comprenant au moins un(e) ».

### TAPIS DE NANOTUBES DE CARBONE

Selon une des caractéristiques essentielles, une structure multicouche selon l'invention présente au moins un tapis de nanotubes de carbone de diamètre unitaire inférieur ou égal à 20 nm, définissant au moins une face de ladite structure.

Comme détaillé dans la suite du texte, le tapis de NTC est destiné à être positionné à l'interface avec la couche active dans l'électrode de la PEMFC.

En particulier, la surface des nanotubes de carbone d'un tapis selon l'invention n'est pas fonctionnalisée par des nanoparticules de catalyseur, par exemple des nanoparticules de platine.

De fait, une structure multicouche selon l'invention est destinée à être combinée avec une couche active conventionnelle pour former une électrode d'un assemblage membrane-électrode dans une pile PEMFC, comme détaillé plus précisément dans la suite du texte.

De préférence, le diamètre unitaire des NTC du tapis selon l'invention est strictement inférieur à 20 nm, en particulier compris entre 2 et 20 nm, et plus particulièrement compris entre 3 et 10 nm.

Il peut être estimé par microscopie électronique à transmission.

La longueur des nanotubes de carbone d'un tapis de NTC selon l'invention peut être comprise entre 1 et 200 µm, en particulier entre 5 et 100 µm, notamment entre 5 et 50 µm et plus particulièrement entre 10 et 20 µm.

De manière avantageuse, un tapis de NTC d'une structure multicouche selon l'invention présente une densité en NTC supérieure ou égale à 10¹¹ NTC par cm², de préférence comprise entre 10¹¹ et 10¹³ NTC par cm².

Un tapis de NTC d'une structure multicouche selon l'invention présente une épaisseur proche de la longueur unitaire des NTC, autrement dit une épaisseur comprise entre 1 µm et 200 µm, en particulier entre 1 µm et 100 µm, notamment entre 5 µm et 50 µm et plus particulièrement entre 10 et 20 µm, l'épaisseur étant définie suivant la direction d'empilement, autrement dit suivant l'axe (X) perpendiculaire à l'interface entre le support à base de fibres de carbone et le tapis de NTC qui lui est superposé.

Le tapis dense de petits NTC selon l'invention peut être plus particulièrement obtenu sous forme de multi feuillets, aussi appelés MWNT (pour « Multi Walled Carbon Nanotubes » en langue anglaise).

Comme évoqué précédemment, un tapis dense de petits NTC selon l'invention peut être formé *via* la réalisation sur au moins une face d'un support à base de fibres de carbone, d'un empilement, dit par la suite « empilement catalytique », à au moins trois couches conductrices. Un tel empilement assure par ailleurs une bonne conduction électrique et thermique entre les NTC et la face dudit support à base de fibres de carbone.

Ainsi, l'interface entre le support à base de fibres de carbone et le tapis de nanotubes de carbone peut comporter, de préférence est formé, d'un empilement de couches minces comportant, dans cet ordre, depuis le support jusqu'au tapis de NTC :
a/ éventuellement, couche métallique en métal M ou couche en alliage métalliques à base du métal M ou couche en graphène, en particulier une couche métallique en métal, et de préférence en fer ;
b/ couche de titane (Ti) ;
c/ couche d'aluminium (Al) ;
d/ couche de matériau(x) catalyseur(s) de la croissance de nanotubes de carbone, en particulier en fer.

Autrement dit, une structure multicouche selon l'invention peut plus particulièrement comprendre au moins une succession de couches superposées et jointives les unes aux autres, dans l'ordre d'empilement suivant :
- couche à base de fibres de carbone ;
- éventuellement, couche métallique en métal M ou couche en alliage métallique à base du métal M ou couche en graphène, en particulier une couche en fer ;
- couche de titane (Ti) ;
- couche d'aluminium (Al) ;
- couche de matériau(x) catalyseur(s) de la croissance de nanotubes de carbone, en particulier en fer ; et
- tapis de NTC.

Lorsqu'elle est présente, la couche métallique M est apte à empêcher la diffusion du Ti dans la structure de fibres de carbone sous-jacente. Il peut ainsi s'agir d'une couche fine d'un métal diffusant peu dans la couche de fibres de carbone, et dans le Ti.

De préférence, le métal M de la couche métallique déposée directement sur la face du support à base de fibres de carbone destinée à supporter le tapis de NTC, est choisi parmi le fer (Fe), le chrome (Cr), le nickel (Ni), le cobalt (Co), le palladium (Pd), ainsi que parmi tous les alliages binaires, ternaires ou quaternaires entre ces métaux.

Selon un mode de réalisation particulier, le métal M est le fer.

Selon encore un autre mode de réalisation particulier, le métal M est de même nature que la couche d/ de matériau catalyseur de la croissance de nanotubes de carbone. Cette couche permet alors de contrôler, *via* son épaisseur, la densité de nanotubes de carbone dans le tapis de nanotubes.

L'épaisseur de cette couche a/ déposée directement sur le support à base de fibres de carbone peut être notamment comprise entre 0,5 et 20 nm.

La bicouche mince Al/Ti a plusieurs fonctions. Elle permet le démouillage du catalyseur et la croissance de NTC selon le mode « base growth », assurant ainsi la croissance de tapis denses de NTC de petits diamètres unitaires, typiquement inférieurs à 10 nm. Elle a également le rôle d'une barrière, à la fois barrière à la diffusion du catalyseur, et surtout de barrière à l'oxydation. Elle permet ainsi de contrôler et réduire l'épaisseur de la couche oxydée se formant le cas échéant pendant la croissance des NTC. Au final, elle permet donc l'obtention d'une excellente conductivité électrique de l'interface.

La couche de Ti peut présenter une épaisseur allant de 2 et 10 nm.

La couche d'Al peut présenter une épaisseur allant de 2 à 10 nm.

L'empilement de couches minces comprenant au moins Ti/Al/Fe, permet la croissance de petits NTC sur le support à base de fibres de carbone, tout en assurant une bonne conduction électrique et thermique entre les NTC et le support.

Selon un mode de réalisation particulier, le ou les matériau(x) catalyseur(s) de la croissance des nanotubes de carbone, de la couche du dessus de l'empilement d'interface, sont choisis parmi le fer (Fe), le chrome (Cr), le nickel (Ni), le cobalt (Co), le palladium (Pd), ainsi que parmi tous les alliages binaires, ternaires ou quaternaires entre ces métaux.

Selon une variante avantageuse, la couche déposée directement sur la face du support à base de fibres de carbone destinée à supporter le tapis de NTC, et la couche de matériau catalyseur de la croissance de NTC sont constituées du même matériau. Ceci permet avantageusement de simplifier le procédé de dépôt des couches minces, notamment par évaporation sous vide dans le même cycle de vide. Ceci permet également de contrôler la densité de nanotube de carbone dans le tapis de nanotube.

L'épaisseur de la couche de matériau(x) catalyseur(s) de la croissance de nanotubes de carbone plus être plus particulièrement comprise entre 0,2 et 5 nm, de préférence entre 0,25 et 2 nm.

Selon un mode de réalisation particulier, l'empilement d'interface selon l'invention, depuis le support à base de fibres de carbone jusqu'au tapis de NTC, peut être le suivant : Fe/Ti/Al/Fe ou Ti/Al/Fe, la couche de fer directement en contact avec la couche sous-jacente à base de fibres de carbone étant le cas échéant d'épaisseur comprise entre 0,5 et 10 nm.

### Support à base de fibres de carbone

Le tapis de nanotubes de carbone selon l'invention est formé à la surface d'un support à base de fibres de carbone.

Il est entendu que le support à base de fibres de carbone doit être compatible avec les différentes étapes du procédé de fabrication du tapis de nanotubes de carbone, à savoir avec les étapes de dépôt de l'empilement catalytique pour la croissance des NTC, et la croissance proprement dite des nanotubes de carbone.

En particulier, la structure chimique et physique du support à base de fibres de carbone, ainsi que ses propriétés mécaniques, ne doivent pas être dégradées, de manière à ce que, d'une part, il conserve ses fonctions et, d'autre part, qu'il n'émette pas de produits susceptibles de polluer le catalyseur de croissance des NTC, ou les équipements nécessaires au procédé de préparation de la structure multicouche selon l'invention.

De fait, comme décrit ci-après, le support à base de fibres de carbone peut être porté à des températures pouvant atteindre 350 à 700 °C lors de la croissance des NTC.

Les supports à base de fibres de carbone, disponibles commercialement et utilisés tels quels, sans traitement préalable, peuvent présenter un risque de pollution du dispositif mis en oeuvre pour la croissance des nanotubes de carbone, préjudiciable à son bon fonctionnement, ainsi que du catalyseur de croissance, ce qui peut induire une baisse d'efficacité du procédé de préparation du tapis de NTC, et en particulier influer sur la taille des nanotubes de carbone obtenus.

De manière avantageuse, les inventeurs ont découvert qu'un traitement thermique spécifique, opéré dans une atmosphère de gaz et à une température spécifique, du support à base de fibres de carbone, préalablement à sa mise en oeuvre comme support pour la croissance d'un tapis de NTC selon l'invention, permet de s'affranchir du risque de pollution évoqué ci-dessus.

Ainsi, selon un mode de réalisation particulier, le support à base de fibres de carbone peut être soumis, préalablement à la réalisation de l'empilement catalytique, à un traitement thermique à une température comprise entre 500 et 700 °C, sous atmosphère de gaz inerte(s), d'air, de dihydrogène, de dioxygène, ou un mélange de ces gaz, en particulier un mélange de gaz inerte(s) et de dihydrogène.

La durée du traitement thermique peut être comprise entre 1 et 5 heures, en particulier être d'environ 2 heures.

A titre d'exemple, le support à base de fibres de carbone, tel que, par exemple, un papier en fibres de carbone commercialisé sous la référence SpectraCarb 2050A0850, SpectraCarb 2050A0550 ou Toray TGP-H-030, peut être traité thermiquement sous air, à 616 °C pendant 2 heures.

Suivant un autre exemple de réalisation, il peut être traité thermiquement dans un mélange de gaz inerte, en particulier d'azote et d'hydrogène, par exemple un mélange 95% molaire N₂/5 % molaire H₂, à 616 °C pendant 2 heures.

### Formation du tapis de nanotubes

Un tapis de NTC selon l'invention peut être formé sur au moins l'une des faces d'un support à base de fibres de carbone, de préférence ayant préalablement subi un traitement thermique tel que décrit ci-dessus, *via* une méthode de croissance de NTC de type « base-growth », faisant intervenir au moins les étapes suivantes :
(i) réalisation sur au moins l'une des faces d'un support à base de fibres de carbone comprenant moins de 30 % massique d'agent(s) hydrophobe(s), en particulier moins de 10 % massique d'agent(s) hydrophobe(s), voire dépourvu d'agent hydrophobe, d'un empilement de couches minces, tel que décrit précédemment ; et
(ii) croissance d'un tapis de nanotubes de carbone sur l'empilement selon une technique de dépôt chimique en phase vapeur (acronyme anglais CVD de « Chemical Vapor Déposition »), assistée ou non par plasma, et activée par filaments chauds (acronyme anglais HFCVD pour « Hot Wire CVD ») ou non.

Selon un mode de réalisation particulier, on effectue, avant d'effectuer l'étape de croissance, une oxydation de la couche de matériau(x) catalyseur(s) au moyen d'un plasma d'air.

L'empilement de couches minces peut être plus particulièrement formé en étape (i), par dépôts successifs des couches minces selon une technique d'évaporation sous vide dans un même cycle de vide. Bien entendu, l'homme du métier est à même de mettre en oeuvre toute autre technique permettant une bonne maîtrise des épaisseurs de couches obtenues.

La croissance des NTC en étape (ii) est de préférence effectuée par HFCVD.

Il appartient à l'homme du métier d'ajuster les conditions de mise en oeuvre du dépôt par CVD, en particulier HFCVD pour obtenir le tapis de NTC souhaité.

Il peut être effectué à partir de l'acétylène comme précurseur de carbone.

Le support à base de fibres de carbone peut être porté à une température allant de 350 °C à 700 °C, en particulier de 400 °C à 500 °C.

Selon un mode de réalisation particulier, le dépôt chimique en phase vapeur est réalisé à une pression allant de 0,1 mbar à 1000 mbar, en particulier de 0,1 à 10 mbar.

La durée de croissance peut être comprise entre 1 minute et 2 heures, en particulier entre 5 minutes et 30 minutes.

Comme détaillé dans les variantes de réalisation qui suivront, une structure multicouche selon l'invention peut avantageusement comprendre au moins deux tapis de NTC, de préférence au moins deux tapis de NTC définissant deux faces opposées de ladite structure.

Il appartient à l'homme du métier d'ajuster les conditions opératoires de manière à faire croître consécutivement ou simultanément les nanotubes de carbone de part et d'autre d'un support à base de fibres de carbone. Ceci implique notamment de procéder au dépôt de l'empilement catalytique de couches au niveau des deux faces du support à base de fibres de carbone.

### STRUCTURES MULTICOUCHES SELON L'INVENTION

Comme évoqué précédemment, une structure multicouche comporte un support à base de fibres de carbone, supportant au moins un tapis de NTC.

De manière avantageuse, le support présente un traitement hydrophobe, de manière à permettre la mise en oeuvre de la structure multicouche selon l'invention comme couche de diffusion dans des PEMFC fonctionnant à basse température.

Ainsi, une structure multicouche selon l'invention peut comprendre un support à base de fibres de carbone imprégné sur tout ou partie de son volume par au moins un agent hydrophobe, et/ou dont la face, opposée à celle supportant ledit tapis de NTC, est hydrophobe ou recouverte d'un film hydrophobe.

Selon une variante de réalisation, le support à base de fibres de carbone est imprégné sur tout ou partie de son volume par au moins un agent hydrophobe et/ou présente sur sa face opposée à celle supportant ledit tapis de NTC, un film incorporant au moins un agent hydrophobe.

Le ou lesdits agents hydrophobes peuvent être notamment choisis parmi des polymères fluorés et perfluorés. Il peut s'agir par exemple de polymères choisis parmi le poly(fluorure de vinylidène) (PVDF), poly(tétrafluoroéthylène) (PTFE), éthylène propylène fluoré (FEP), poly(vinylidene fluoride-co-hexafluoropropylene) (PVDF-HFP), poly(éthylène-co-tétrafluoroéthylène) (ETFE) ou perfluoroalkoxy (PFA).

Le traitement d'imprégnation/dépôt peut être plus particulièrement réalisé à partir d'une suspension ou solution du ou desdits agent(s) hydrophobe(s), en particulier dudit polymère hydrophobe fluoré ou perfluoré, par exemple le PTFE. Il comprend plus particulièrement la pulvérisation de ladite suspension ou solution en surface de la face à traiter, ou par immersion totale ou partielle du substrat dans la suspension ou solution dudit ou desdits agent(s) hydrophobe(s), suivie d'une étape de séchage propice à l'évaporation des solvants.

Selon une autre variante de réalisation, la face du support à base de fibres de carbone, opposée à celle supportant le tapis de NTC, est traité par plasma pour lui conférer des propriétés hydrophobes. Le traitement plasma comprend plus particulièrement l'exposition de la face à traiter à un plasma réactif comprenant un ou plusieurs gaz fluoré(s).

Ce traitement plasma peut être effectué sur l'une ou l'autre des faces du support à base de fibres de carbones, avant ou après la croissance du tapis de nanotubes de carbone. De préférence, le traitement plasma est effectué après la croissance du tapis de nanotubes de carbone, et sur la face opposée à celle supportant le tapis de NTC, comme détaillé dans la suite du texte.

Le traitement plasma peut être effectué dans divers types de réacteurs plasma, incluant notamment les réacteurs plasma à couplage radio-fréquence inductif, les réacteurs plasma à couplage radio-fréquence capacitif et les réacteurs plasma excités par micro-ondes.

Le ou les gaz fluoré(s) peuvent être notamment choisis parmi l'hexafluorure de soufre (SF₆), le tétrafluorométhane (CF₄), le trifluorométhane (CHF₃), le difluorométhane (CH₂F₂), le perfluorocyclobutane (C₄F₈) et leurs mélanges. Le ou les gaz fluoré(s) sont plus particulièrement dilués avec d'autres gaz, comme par exemple l'argon, l'ammoniaque ou le dihydrogène.

L'ajustement des conditions de mise en oeuvre du traitement plasma pour obtenir une surface hydrophobe relève des compétences de l'homme du métier.

A titre d'exemple, le traitement plasma peut être effectué dans un réacteur à couplage radio-fréquence capacitif dans les conditions suivantes : 100 SCCM de SF₆ à 100 mTorr, avec une puissance RF (13,56 MHz) de 100 W pendant 2 minutes.

A titre d'exemple encore, le traitement plasma peut être effectué dans un réacteur à couplage radio-fréquence inductif dans les conditions suivantes : 100 SCCM de CF₄ à 20 mTorr, avec une puissance RF (13,56 MHz) de 500 W pendant 5 minutes.

### 1^{ère} variante : substrat carboné supportant une couche à base de fibres de carbone

Selon une première variante de réalisation, le support à base de fibres de carbone d'une structure multicouche selon l'invention peut comprendre :
- un substrat (3) à base de fibres de carbone, de préférence hydrophobe, en particulier imprégné par au moins un agent hydrophobe ; et
- une couche (2) à base de fibres de carbone, portée par au moins l'une des faces dudit substrat, comprenant moins de 30 % massique en agent(s) hydrophobe(s), en particulier moins de 10 % massique en agent(s) hydrophobe et plus particulièrement dépourvue d'agent hydrophobe,
ladite couche présentant, sur au moins sa face opposée audit substrat, ledit tapis de NTC (1).

Une telle structuration de la structure multicouche en deux parties, substrat traité hydrophobe/couche à base de fibres de carbone non hydrophobe, permet d'empêcher, lors de la préparation de la structure multicouche selon l'invention, toute interaction entre l'agent hydrophobe et le tapis de NTC susceptible d'impacter l'organisation et la nanostructure des NTC.

Une telle structure est représentée schématiquement en figure 2. Comme signalé précédemment, il est entendu que l'empilement catalytique d'interface tel que décrit précédemment, pouvant être présent entre la couche (2) à base de fibres de carbone et le tapis (1) de NTC, n'est pas représenté sur les figures annexées.

Le substrat (3) à base de fibres de carbone sera plus simplement désigné dans la suite du texte sous l'appellation « substrat carboné ».

Il peut être du type des substrats classiquement mis en oeuvre pour supporter la couche microporeuse (MPL) dans une électrode d'une PEMFC conventionnelle.

Le substrat carboné peut prendre la forme d'un feutre, papier ou tissu. Il s'agit généralement d'un non-tissé de fibres de carbone.

Le substrat carboné présente avantageusement une porosité comprise entre 60 et 85 %, en particulier entre 70 et 80 %. La porosité correspond au pourcentage de volume de vide dans le substrat en carbone par rapport à son volume total.

Le substrat carboné peut présenter une épaisseur comprise entre 50 et 400 micromètres, en particulier entre 100 et 200 micromètres.

A titre d'exemple de substrat carboné, on peut citer le papier en fibres de carbone commercialisé sous la référence Toray TGP-H-030.

Comme indiqué précédemment, le substrat à base de fibres de carbone est avantageusement hydrophobe. De préférence, il est imprégné par au moins un agent hydrophobe, en particulier tel que défini ci-dessus. Il peut s'agir par exemple du polytétrafluoréthylène (ou PTFE).

On désignera plus simplement dans la suite du texte le substrat à base de fibres de carbone, ayant subi un traitement hydrophobe, en particulier imprégné par au moins un agent hydrophobe sous l'appellation « substrat carboné hydrophobe ».

De manière avantageuse, le substrat en carbone peut comprendre entre 2 et 40 % en poids, en particulier entre 5 et 15 % en poids d'agent(s) hydrophobe(s), par rapport à son poids total.

A titre d'exemple, on peut citer le papier en fibres de carbone commercialisé sous la référence Toray TGP-H-030, traité avec 5 à 20 % en poids d'agent(s) hydrophobe(s), de préférence en PTFE.

Concernant la couche (2) à base de fibres de carbone, les fibres de carbone de ladite couche peuvent être identiques ou non à celles du substrat carboné.

La couche (2) comprend moins de 30 % en poids d'agent(s) hydrophobe(s), en particulier moins de 20 % en poids d'agent(s) hydrophobe(s) et plus particulièrement moins de 10 % en poids d'agent(s) hydrophobe(s).

De préférence, la couche (2) est être totalement dénuée d'agent hydrophobe.

La couche à base de fibres de carbone présente avantageusement une porosité comprise entre 60 et 85 %, en particulier entre 70 et 80 %.

Elle peut présenter une épaisseur comprise entre 40 et 200 micromètres, en particulier entre 40 et 100 micromètres.

En particulier, l'épaisseur de l'ensemble formé par la couche à base de fibres de carbone surmontée du tapis de nanotubes de carbone (y compris l'empilement catalytique d'interface entre la couche carbonée et le tapis) peut être comprise entre 50 et 220 µm, en particulier entre 60 et 120 µm.

### Préparation de la structure multicouche

Le procédé de préparation d'une structure multicouche selon cette première variante de réalisation peut comprendre plus particulièrement au moins les étapes suivantes :
(al) réalisation, selon les étapes (i) et (ii) précitées, d'un tapis de NTC sur au moins une des faces d'un support à base de fibres de carbone, comportant moins de 30 % massique d'agent(s) hydrophobe(s), en particulier moins de 10 % massique d'agent(s) hydrophobe(s), de préférence dépourvu en agent hydrophobe ; et
(a2) dépôt d'un support préparé selon l'étape (al) sur au moins l'une des faces d'un substrat carboné, de préférence ayant préalablement subi un traitement hydrophobe, en particulier préalablement imprégné par au moins un agent hydrophobe,
   au moins un tapis de NTC étant présent sur la face du support opposée audit substrat carboné.

Le support en étape (a1), destiné à former la couche à base de fibres de carbone de la structure multicouche, telle que décrite précédemment, peut être notamment un non-tissé de fibres de carbone.

A titre d'exemples de supports à base de fibres de carbone, on peut citer les papiers composites de fibres de carbone commercialisés sous les références Freudenberg H14 ou H15 ou Toray TGP-H-030.

Comme indiqué précédemment, le support à base de fibres de carbone peut être, préalablement à la fabrication du tapis de NTC, traité thermiquement, en particulier à une température comprise entre 500 et 700 °C, sous atmosphère de gaz inerte(s), d'air, de dihydrogène, de dioxygène, ou un mélange de ces gaz, en particulier un mélange de gaz inerte(s) et de dihydrogène.

Le dépôt, en étape (a2), du support portant sur au moins l'une de ses faces un tapis de NTC selon l'invention, en surface d'un substrat carboné ayant déjà subi un traitement hydrophobe permet d'éviter tout risque d'interaction néfaste entre le tapis de NTC et le traitement hydrophobe.

Le traitement hydrophobe du substrat effectué, préalablement à l'étape (a2), peut être opéré ainsi par différentes méthodes, comme décrit précédemment.

De préférence, il s'agit d'un traitement d'imprégnation avec au moins un agent hydrophobe, en particulier un polymère hydrophobe, comme décrit précédemment.

Un tel traitement d'imprégnation avec un polymère hydrophobe peut être réalisé par exemple à partir d'une suspension ou solution dudit polymère hydrophobe, comme par exemple le PTFE, par :
- immersion du substrat dans la suspension ou solution dudit polymère hydrophobe ;
- séchage du substrat imprégné/évaporation des solvants ;
- éventuellement frittage du substrat séché.

Les deux premières étapes peuvent être réitérées de manière à atteindre la concentration en agent hydrophobe désirée.

D'autres traitements d'imprégnation du substrat carboné peuvent être mis en oeuvre, tel que, par exemple, celui décrit dans la demande EP 3 206 247.

### Variantes de structures multicouches

Selon un mode de réalisation particulier, l'étape (al) peut comprendre la réalisation de tapis de NTC de part et d'autre du support à base de fibres de carbone.

Plus précisément, un empilement catalytique de couches minces peut être réalisé, selon l'étape (i) décrite précédemment, de part et d'autre du support à base de fibres de carbone, puis la croissance des NTC opérée par CVD, en particulier par HFCVD, consécutivement ou simultanément de part et d'autre du support.

Dans le cadre de ce mode de réalisation, à l'issue du dépôt, selon l'étape (a2) décrite ci-dessus, dudit support sur un substrat de carbone, la structure multicouche (10) selon l'invention comprend ainsi, outre un premier tapis de surface (1), un deuxième tapis de NTC (1) intercalé entre le substrat carboné (3) et la couche à base de fibres de carbone (2).

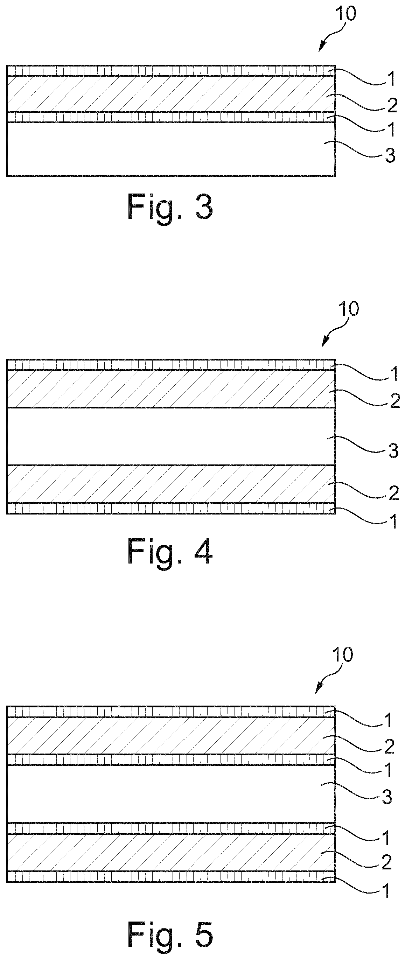

Une telle structure est représentée schématiquement en figure 3.

La présence d'un tapis de NTC à l'interface entre la couche à base de fibres de carbone (2) et le substrat carboné (3) présente l'avantage de permettre un meilleur contact entre ladite couche et le substrat carboné. De fait, la surface de contact est accrue pour une interface entre un tapis de NTC et les fibres de carbone du substrat (3), comparativement à une interface entre les fibres de carbone de la couche (2) et celles du substrat (3).

Une structure multicouche, utile comme couche de diffusion composite dans une PEMFC selon l'invention, peut ainsi comprendre la succession de couches superposées suivante :
- substrat (3) à base de fibres carbone, de préférence hydrophobe, en particulier imprégné par au moins un agent hydrophobe ;
- tapis de NTC (1) ;
- couche (2) à base de fibres de carbone, incorporant moins de 30 % massique d'agent hydrophobe, en particulier moins de 10 % massique d'agent hydrophobe, de préférence exempte d'agent hydrophobe ; et
- tapis de NTC (1), ce dernier tapis de NTC définissant une face de ladite structure multicouche et étant destiné à être en contact avec la couche catalytique (ou couche active) de l'électrode de la PEMFC.

Selon un autre mode de réalisation particulier, une structure multicouche selon l'invention peut comprendre au moins deux tapis de NTC définissant deux faces opposées de ladite structure.

Ainsi, selon une variante de réalisation, l'étape (a2) peut comprendre le dépôt de supports préparés selon l'étape (al) de part et d'autre du substrat carboné hydrophobe, chacun des tapis de NTC étant au moins présent sur les faces des supports opposées audit substrat carboné.

La structure multicouche ainsi formée comprend un substrat carboné hydrophobe (3), intercalé entre deux couches à base de fibres de carbone, incorporant moins de 30 % massique d'agent hydrophobe, en particulier moins de 10 % massique d'agent hydrophobe, et de préférence exemptes d'agent hydrophobe, chacune des couches (2) présentant sur sa face opposée au substrat carboné (3), un tapis de NTC (1) selon l'invention.

Cette variante de réalisation est représentée schématiquement en figure 4.

Une telle structure multicouche, présentant au niveau de ses deux faces opposées, deux tapis de NTC est particulièrement avantageuse lors de sa mise en oeuvre comme couche de diffusion dans une PEMFC. De fait, la présence d'un tapis de NTC, à l'interface de la couche de diffusion avec la plaque collecteur de courant, bipolaire, de l'électrode, permet avantageusement d'améliorer le contact électrique entre la couche de diffusion et la plaque bipolaire. De fait, au lieu d'un contact entre des fibres de carbone et la plaque bipolaire de type cylindre/plan, la surface de contact est augmentée entre la couche de diffusion et la plaque bipolaire du fait de la présence à l'interface d'un tapis de NTC. Ainsi, la résistance de contact entre la couche de diffusion et la plaque bipolaire résultante est avantageusement réduite.

Il est entendu que les différentes variantes et modes de réalisation précités peuvent être combinés, dans la mesure du possible, pour réaliser d'autres variantes de structure multicouche selon l'invention utile comme couche de diffusion dans une PEMFC.

Ainsi, par exemple, une structure multicouche selon l'invention peut comprendre un substrat carboné hydrophobe (3), intercalé entre deux couches (2) à base de fibres de carbone, incorporant moins de 30 % massique d'agent hydrophobe, en particulier moins de 10 % massique d'agent hydrophobe, de préférence exempte d'agent hydrophobe, chacune de ces couches présentant sur chacune de leurs faces, un tapis de NTC selon l'invention.

Cette variante de réalisation est représentée schématiquement en figure 5.

Une structure multicouche, utile comme couche de diffusion composite dans une PEMFC selon l'invention, peut ainsi comprendre la succession de couches superposées suivante :
- tapis de NTC ;
- couche à base de fibres de carbone, incorporant moins de 30 % massique d'agent hydrophobe, de préférence exempte d'agent hydrophobe ;
- tapis de NTC ;
- substrat carboné avantageusement hydrophobe ;
- tapis de NTC ;
- couche à base de fibres de carbone, incorporant moins de 30 % massique d'agent hydrophobe, de préférence exempte d'agent hydrophobe ; et
- tapis de NTC,
l'un des tapis de NTC définissant une face de ladite structure multicouche étant destiné à être contact avec la couche catalytique (ou couche active) de l'électrode dans la PEMFC dans laquelle la couche de diffusion sera mise en oeuvre.

### 2^{ème} variante : substrat carboné éventuellement traité hydrophobe

Selon encore une autre variante de réalisation, le support à base de fibres de carbone d'une structure multicouche selon l'invention peut être formé d'un substrat massif (4) à base de fibres de carbone, présentant sur l'une de ses faces ledit tapis de nanotubes de carbone et présentant éventuellement, au niveau de sa face opposée à celle supportant le tapis de NTC, des propriétés hydrophobes, en particulier étant imprégné, au niveau de sa face opposée à celle supportant le tapis de NTC, par au moins un agent hydrophobe, et/ou dont la face, opposée au tapis de NTC, est hydrophobe ou recouverte d'un film hydrophobe.

On entend signifier par « substrat massif », le fait que le support à base de fibres de carbone ne résulte pas, à la différence de la première variante détaillée ci-dessus, de l'empilement d'une ou plusieurs couches à base de fibres de carbone.

Le substrat massif (4) à base de fibres de carbone, dit par la suite « substrat carboné » peut être tel que décrit précédemment. Il peut prendre la forme d'un feutre, papier ou tissu. Il s'agit généralement d'un non-tissé de fibres de carbone.

Le substrat carboné présente avantageusement une porosité comprise entre 60 et 85 %, en particulier entre 70 et 80 %. La porosité correspond au pourcentage de volume de vide dans le substrat en carbone par rapport à son volume total.

Le substrat carboné peut présenter une épaisseur comprise entre 80 et 400 micromètres, en particulier entre 100 et 200 micromètres.

A titre d'exemple de substrat carboné, on peut citer le papier en fibres de carbone commercialisé sous la référence Toray TGP-H-090.

Dans le cas où un traitement hydrophobe de la structure multicouche n'est pas requis, typiquement pour sa mise en oeuvre dans une PEMFC-HT, le substrat en fibres de carbone peut avantageusement présenter sur chacune de ses faces opposées un tapis de NTC.

Comme évoqué précédemment, la présence d'un tapis de NTC, à l'interface de la couche de diffusion avec la plaque collecteur de courant de l'électrode de la PEMFC, permet avantageusement de réduire la résistance de contact entre la couche de diffusion et la plaque collectrice de courant.

Selon un autre mode de réalisation particulier, le substrat carboné (4) peut être présenter, au niveau de sa face opposée à celle supportant le tapis de NTC, des propriétés hydrophobes, en particulier être imprégné au niveau de sa face opposée à celle supportant le tapis de NTC, par au moins un agent hydrophobe, et/ou présenter sur ladite face opposée au tapis de NTCun film comportant, voire étant formé, d'au moins un agent hydrophobe.

L'agent hydrophobe peut être plus particulièrement choisi parmi les polymères hydrophobes tels que décrits précédemment. Il peut s'agir par exemple du PTFE.

De préférence, le substrat carboné (4) est ainsi imprégné sur une épaisseur, e, s'étendant depuis sa face opposée à celle supportant le tapis de NTC, strictement inférieure à l'épaisseur totale du substrat. Ceci permet ainsi d'éviter tout contact avec le tapis de NTC.

En particulier, l'épaisseur d'imprégnation, notée e, peut représenter moins de 95 % de l'épaisseur totale du substrat, en particulier moins de 90 %, plus particulièrement moins de 80 % et notamment moins de 60 % de l'épaisseur totale du substrat. Elle est en particulier comprise entre 20 et 180 µm, de préférence entre 40 et 100 µm.

L'épaisseur d'imprégnation peut être estimée par cartographie EDX dans un MEB sur une coupe de l'échantillon.

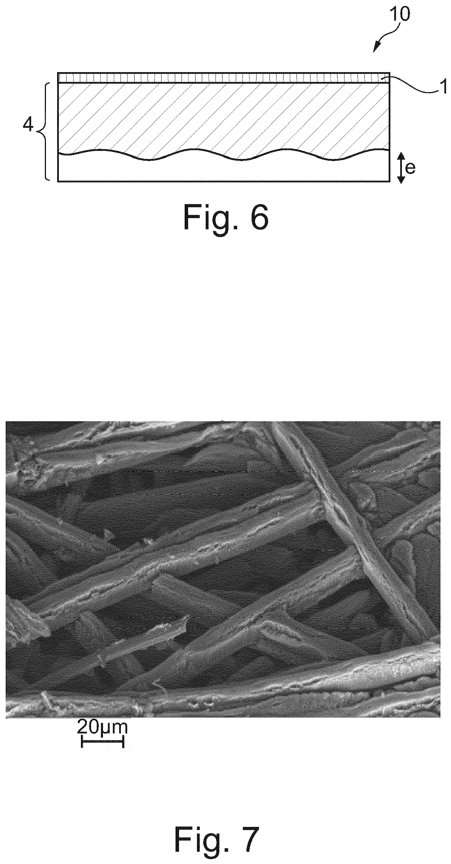

Une telle variante de structure multicouche selon l'invention est représentée en figure 6.

De préférence, la partie du substrat imprégnée présente un taux de chargement en agent(s) hydrophobe(s) comprise entre 2 et 40 % en poids, en particulier entre 5 et 15 % en poids.

Alternativement, les propriétés hydrophobes de la face du substrat carboné, opposée à celle supportant le tapis de NTC, peuvent être obtenues par traitement plasma, comme décrit précédemment.

### Préparation de la structure multicouche,

Le procédé de préparation d'une structure multicouche selon cette variante de réalisation peut comprendre plus particulièrement au moins les étapes suivantes :
(b1) réalisation, selon les étapes (i) et (ii) précitées, d'un tapis de NTC sur au moins une des faces d'un substrat à base de fibres de carbone, comportant moins de 30 % massique d'agent(s) hydrophobe(s), en particulier moins de 10 % massique d'agent(s) hydrophobe(s), de préférence dépourvu en agent hydrophobe ;
   et éventuellement, dans le cas de la formation d'un tapis de NTC sur une unique face dudit substrat,
(b2) traitement hydrophobe du substrat au niveau de la face opposée à celle supportant le tapis de NTC, en particulier par imprégnation du substrat, au niveau de la face opposée à celle supportant le tapis de NTC, par au moins un agent hydrophobe, formation sur la face opposée à celle supportant le tapis de NTC, d'un film comportant, voire étant formé, d'au moins un agent hydrophobe, et/ou par un traitement plasma avec un gaz fluoré, ledit traitement hydrophobe étant opéré dans des conditions ajustées de manière à ne pas affecter la structure du tapis de NTC formé en étape (b1).

Comme indiqué précédemment, le substrat à base de fibres de carbone peut être, préalablement à la fabrication du tapis de NTC, traité thermiquement, en particulier à une température comprise entre 500 et 700 °C, sous atmosphère de gaz inerte(s), d'air, de dihydrogène, de dioxygène, ou un mélange de ces gaz, en particulier un mélange de gaz inerte(s) et de dihydrogène.

Comme évoqué ci-dessus, dans le cas où un traitement hydrophobe de la couche de diffusion est inutile, l'étape (b1) peut comprendre la réalisation de tapis de NTC de part et d'autre du substrat à base de fibres de carbone. Plus précisément, un empilement catalytique de couches minces peut être alors réalisé, selon l'étape (i) décrite précédemment, de part et d'autre du substrat à base de fibres de carbone, puis la croissance des NTC opérée par CVD, en particulier par HFCVD, consécutivement ou simultanément de part et d'autre du substrat.

Dans le cadre de la mise en oeuvre d'un traitement hydrophobe (étape (b2)), il importe que ce traitement hydrophobe, par exemple par imprégnation du substrat par l'agent hydrophobe, ne perturbe pas la structure du tapis de NTC préalablement formé en étape (b1).

L'homme du métier est à même d'ajuster les conditions de mise en oeuvre en étape (b2) du traitement hydrophobe, par exemple d'imprégnation, de dépôt de l'agent hydrophobe à la surface du substrat ou encore de traitement plasma, de manière à qu'il n'affecte pas la structure du tapis de NTC. En particulier, le traitement d'imprégnation est opéré de manière à ce que l'agent hydrophobe ne pénètre pas la structure de la couche de NTC.

Comme décrit dans le cadre de la première variante, le traitement d'imprégnation/dépôt peut être réalisé à partir d'une suspension ou solution dudit agent hydrophobe, en particulier du polymère hydrophobe fluoré ou perfluoré, comme par exemple le PTFE, par pulvérisation de ladite suspension ou solution en surface de la face opposée à celle supportant le tapis de NTC ; ou par immersion partielle du substrat dans la suspension ou solution dudit agent hydrophobe.

L'étape de dépôt/imprégnation peut être suivie d'une étape de séchage propice à évaporer le ou les solvants. Egalement, peuvent être mises en oeuvre une ou plusieurs étapes de traitement thermique visant à détruire les impuretés organiques, stabiliser le film de polymère hydrophobe en surface du substrat de carbone et/ou fritter le polymère. Le frittage permet de faire fluer le polymère sous forme de particules pour former un film.

Il appartient à l'homme du métier d'ajuster les conditions, en particulier la température et la durée, du traitement thermique au regard, d'une part, de l'agent hydrophobe mis en oeuvre et, d'autre part, de manière à prévenir toute dégradation dudit agent hydrophobe et du tapis de NTC.

De préférence, le substrat, pendant toute la durée du traitement hydrophobe, est maintenu à une température inférieure ou égale à 500 °C, de préférence inférieure ou égale à 400 °C. La durée du traitement thermique peut être comprise entre 2 et 60 minutes, en particulier entre 5 et 30 minutes.

Alternativement, la face du substrat, opposée à celle supportant le tapis de NTC, peut être exposée à un traitement plasma avec un plasma contenant au moins un gaz fluoré, comme décrit précédemment, afin de lui conférer des propriétés hydrophobes.

### APPLICATION DE LA STRUCTURE MULTICOUCHE

Une structure multicouche selon l'invention présente avantageusement une épaisseur totale comprise entre 100 et 600 µm, de préférence entre 100 et 300 µm et avantageusement entre 150 et 250 µm.

Comme évoqué précédemment, une structure multicouche sert avantageusement de couche de diffusion dans une électrode d'une PEMFC, au moins un tapis de NTC de ladite structure multicouche étant positionné en contact avec la couche active (également appelée couche catalytique) de l'électrode.

L'invention concerne ainsi, selon encore un autre de ses aspects, une électrode, en particulier cathode, pour une PEMFC, comportant une structure multicouche selon l'invention, au moins un tapis de NTC de ladite structure étant positionnée en contact avec la couche active de l'électrode.

Elle se rapporte encore, selon un autre de ses aspects, à une pile à combustible à membrane échangeuse de protons comprenant au moins une telle électrode. De préférence, une pile PEMFC comprend deux électrodes, anode et cathode, conformes à l'invention.

Dans le cadre de la préparation d'une électrode pour une PEMFC fonctionnant à basse température (PEMFC-LT), la structure multicouche est traitée hydrophobe. En particulier, le support à base de fibres de carbone est imprégné sur tout ou partie de son volume par au moins un agent hydrophobe selon l'une des variantes de réalisation décrites précédemment.

Les autres constituants de l'électrode intégrant une structure multicouche selon l'invention, et de la PEMFC, sont ceux classiquement mis en oeuvre dans les piles.

Typiquement, une électrode d'une PEMFC selon l'invention comprend ainsi l'assemblage suivant :
- éventuellement, une plaque collectrice de courant,
- une couche de diffusion formée d'une structure multicouche selon l'invention ; et
- une couche active (également appelée couche catalytique).

Au moins un tapis de NTC de la structure multicouche selon l'invention est positionné à l'interface avec la couche active, autrement dit, en lieu et place de la couche microporeuse (MPL) des structures classiques d'électrode.

Dans le cadre d'une structure multicouche de NTC présentant deux tapis de NTC définissant deux faces opposées de ladite structure, un tapis de NTC constitue également l'interface de la couche de diffusion avec la plaque collectrice de courant.

Les plaques collectrices de courant qui encadrent l'assemblage membrane-électrodes du coeur de pile ont, en plus de la fonction de collecteur de courant, une fonction de transport fluidique, pour la distribution des réactifs et l'écoulement de l'eau ou la vapeur d'eau produite. Ces plaques sont généralement des plaques en graphite et les canaux d'écoulement sont obtenus par usinage.

La couche catalytique ou couche active est poreuse, généralement constituée de nano-particules de platine qui forment les sites catalytiques, supportées par des agrégats de carbone.

Une pile PEMFC selon l'invention comprend au moins une électrode intégrant une couche de diffusion selon l'invention, de préférence deux électrodes, anode et cathode, intégrant chacune une couche de diffusion selon l'invention.

Les deux électrodes d'une PEMFC encadrent une membrane électrolytique de type polymérique, permettant le passage des protons (H⁺) mais imperméable aux réactifs.

L'agencement et la préparation des électrodes, et d'une pile PEMFC, intégrant une/des couche(s) de diffusion selon l'invention, relèvent bien entendu des techniques connues de l'homme du métier.

Plus particulièrement, un assemblage membrane-électrode d'une pile PEMFC selon l'invention comprend au moins la succession des couches suivantes, dans cet ordre :
- un support à base de fibres de carbone ;
- un tapis de NTC selon l'invention ;
   la structure formée d'au moins dudit support et dudit tapis de NTC constituant la couche dite couche de diffusion ;
- une couche active ; et
- une membrane conductrice protonique.

La couche de diffusion composite selon l'invention peut être typiquement intégrée dans un assemblage membrane-électrode de deux façons, comme décrit notamment par Liu *et al.* [6].

Selon une première variante de réalisation, une couche active peut être fabriquée ou déposée sur la couche de diffusion selon l'invention, pour obtenir une électrode à diffusion gazeuse ou « GDE » (pour « Gas Diffusion Electrode » en langue anglaise), puis l'électrode est ensuite assemblée avec une membrane conductrice protonique.

Plus précisément, la couche active peut être réalisée en surface de la couche de diffusion selon l'invention selon des techniques connues de l'homme du métier, typiquement par voie liquide. A titre d'exemple, elle peut être formée par dépôt, par exemple par enduction, sérigraphie ou pulvérisation, sur la couche de diffusion, d'une dispersion de catalyseur, par exemple de particules de platine, et de polymère conducteur protonique (par exemple, de type perfluorosulfoné comme le Nafion®), dans un ou plusieurs solvants de type eau/alcool, suivie de l'évaporation du ou des solvants.

La GDE ainsi formée peut ensuite être assemblée avec la membrane conductrice protonique par pressage à chaud, en particulier en ajustant de manière adéquate 1 température, la contrainte et le temps de pressage à chaud. Par exemple, l'assemblage peut être réalisé par pressage à 135°C à 3,5 MPa, pendant 3 minutes et 30 secondes.

La GDE ainsi formée peut être utilisée comme anode, comme cathode ou pour les deux électrodes d'un assemblage membrane-électrode dans une PEMFC.

Selon une autre variante de réalisation, la couche de diffusion selon l'invention peut être associée à un ensemble comprenant la membrane et au moins une des couches actives anodique ou cathodique, généralement les deux couches actives. Cet ensemble est appelé CCM pour « Catalyst Coated Membrane » en langue anglaise. La couche de diffusion est ensuite associée par contact ou pressage à chaud à la CCM pour obtenir l'assemblage membrane-électrode.

L'invention va maintenant être décrite au moyen des exemples suivants, donnés bien entendu à titre illustratif et non limitatif de l'invention.

### EXEMPLES

### EXEMPLE 1

### Préparation d'une structure multicouche selon l'invention

### 1.1. Formation d'un tapis de NTC en surface d'un support à base de fibres de carbone

Un tapis de nanotubes de carbone est formé au niveau de l'une des faces d'un papier de carbone, commercialisé sous la référence Toray TGP-H-030 n'ayant pas subi de traitement hydrophobe, suivant le protocole suivant.

Avantageusement, le papier de carbone peut être traité thermiquement sous air ou dans un mélange 95% molaire N₂/5% molaire H₂, à 616 °C pendant 2 heures.

Dans une première étape, un empilement de couches minces comportant une couche de matériau catalyseur est réalisé comme suit sur l'une des faces du papier à base de fibres de carbone.

Des couches minces de fer (2 nm), de titane (5 nm), d'aluminium (2 nm) et de fer (1 nm) sont déposées successivement, dans cet ordre, sur l'une des faces du papier de carbone. L'empilement résultant est donc du type papier carbone/Fe/Ti/Al/Fe.

Les différentes couches de l'empilement sont déposées sous incidence normale par une technique de dépôt physique en phase gazeuse (PVD pour « Physical Vapor Déposition » en langue anglaise), à l'aide d'un canon à électrons à température ambiante.

On réalise ensuite la croissance d'un tapis de NTC par une technique de dépôt chimique en phase vapeur (CVD pour « Chemical Vapor Déposition » en langue anglaise) activé par filaments chauds, également connue sous l'acronyme anglais de HFCVD pour « Hot Filament Vapor Deposition »).

Après pompage sous vide, l'échantillon est monté en température à 450 °C en 12 minutes, sous une pression de 0,3 Torr d'un mélange gazeux de C₂H₂/H₂/He, avec les débits respectifs de 10, 55 et 110 sccm.

L'unité de débit, indiquée sous l'acronyme anglais sccm pour « standard cubic centimeters per minute », correspond à l'unité d'un débit d'un centimètre cube par minute dans les conditions de température à 0 °C et de pression à 101,325 kPa.

Les filaments chauds composés de 6 fils de carbone de 0,5 mm de diamètre sont alors mis en route avec une puissance de 500 W. Les filaments fonctionnent à cette puissance pendant 20 minutes.

Après arrêt des filaments, le chauffage est coupé et la descente en température se fait sous hélium à une pression de 0,45 Torr.

A l'issue de ce procédé, un tapis de NTC de densité de 10¹² tubes/cm² est obtenu sur les fibres de carbone. Les NTC présentent un diamètre unitaire moyen d'environ 5 nm et une longueur d'environ 10 µm.

La figure 7 représente une image, obtenue par microscopie électronique à balayage du tapis de NTC obtenu sur les fibres de carbone.

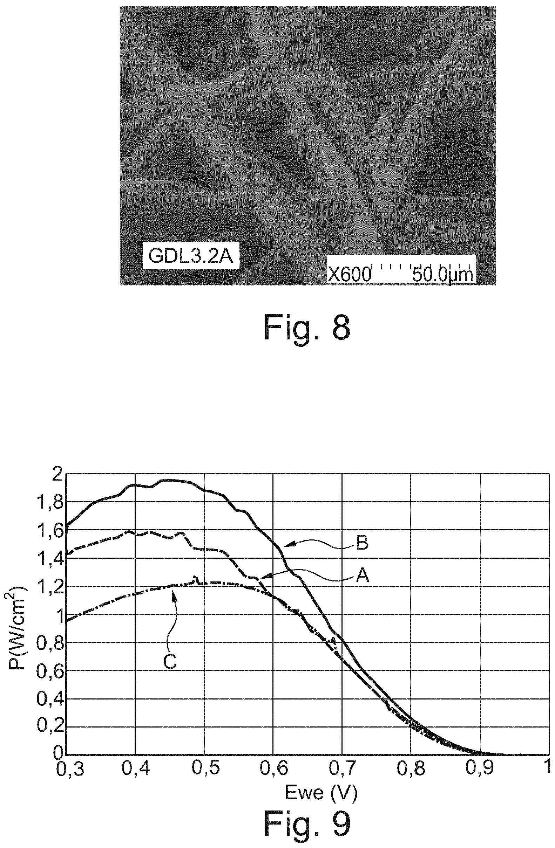

Alternativement, un tapis de NTC peut être formé à partir du dépôt de l'empilement catalyseur de type Ti/Al/Fe (donc en l'absence de la première couche de fer). Dans ces conditions, le tapis de NTC formé fait 20 µm de haut en suivant le procédé décrit précédemment et la densité de tubes est de 2.10¹¹ tubes/cm². La figure 8 représente une image, obtenue par microscopie électronique à balayage du tapis de NTC obtenu sur les fibres de carbone.

### 1.2. Dépôt sur un substrat à base de fibres de carbone traité par un agent hydrophobe

La couche à base de fibres de carbone à la surface de laquelle est formé un tapis de NTC est ensuite déposée sur un papier de carbone Toray TGP-H-030 préalablement traité avec 10 % en poids d'agent hydrophobe PTFE.

La structure multicouche ainsi formée est représentée schématiquement en Figure 2.

Elle peut être mise en oeuvre comme couche de diffusion au niveau d'une ou des électrode(s) d'une pile à combustible à membrane échangeuse de protons conventionnelle, en remplacement de la couche microporeuse (MPL) classiquement réalisée à base de noir de carbone, de graphène ou de graphite, le tapis de NTC étant positionné à l'interface avec la couche active.

Alternativement, la couche à base de fibres de carbone intégrant un tapis de NTC obtenue comme décrit précédemment peut être ensuite déposée sur un support poreux à base de fibres de carbone, par exemple commercialisé sous la référence Freudenberg H14 ou H15, préalablement traité par 10 % en poids de PTFE par imprégnation.

### EXEMPLE 2

### Préparation d'une structure multicouche selon l'invention

### 1.1. Formation d'un tapis de NTC en surface d'un substrat à base de fibres de carbone

Dans une première étape, un tapis de NTC est formé sur l'une des faces d'un substrat à base de fibre de carbone, commercialisé sous la référence Toray TGP-H-090, suivant le protocole décrit en exemple 1 ci-dessus.

### 1.2. Imprégnation du substrat par un agent hydrophobe

Dans une seconde étape, le substrat est imprégné sur une épaisseur e s'étendant depuis la face opposée au tapis de NTC et inférieure à l'épaisseur totale du substrat, par un agent hydrophobe (polytétrafluoroéthylène, PTFE).

Pour ce faire, une suspension aqueuse de PTFE à 60 % massique est pulvérisée par spray pour obtenir une imprégnation du substrat à raison de 5 à 10 % massique.

Alternativement, on peut utiliser une suspension de PTFE en ajoutant jusqu'à 50 % en volume d'éthanol, de façon à avoir une meilleure mouillabilité du substrat.

On procède ensuite à un traitement thermique, idéalement sous atmosphère inerte, à 360 °C, pendant 5 minutes, afin de fritter le PTFE.

A l'issue du traitement hydrophobe, la structure multi-couche obtenue, telle que représentée en figure 6, peut être mise en oeuvre comme couche de diffusion dans une pile à combustible à membrane échangeuse de protons conventionnelle, en remplacement de la couche microporeuse (MPL), le tapis de NTC étant positionné à l'interface avec la couche active.

Selon une variante de réalisation, la face, opposée au tapis de NTC, peut être rendue hydrophobe *via* un traitement plasma effectué dans un réacteur radio-fréquence capacitif dans les conditions suivantes : 100 SCCM de SF₆ à 100 mTorr, avec une puissance RF (13,56 MHz) de 100 W pendant 2 minutes. Alternativement, le traitement plasma peut être effectué dans un réacteur à couplage radio-fréquence inductif dans les conditions suivantes : 100 SCCM de CF₄ à 20 mTorr, avec une puissance RF (13,56 MHz) de 500 W pendant 5 minutes.

### EXEMPLE 3

### Performances des PEMFC intégrant une couche de diffusion selon l'invention

### 3.1. Préparation des couches de diffusion selon l'invention

Une première structure multicouche (A) selon l'invention est préparée comme décrit en exemple 1.

La structure multicouche ainsi obtenue, composée de deux parties (substrat carboné/couche à base de fibres de carbone avec tapis de NTC), est représentée schématiquement en figure 2.

Une deuxième structure multicouche (B) selon l'invention est préparée suivant le même protocole que celui de la première structure, excepté le fait que deux tapis de nanotubes sont formés de part et d'autre du support carboné.

La structure multicouche obtenue selon cette variante, composée de trois parties (couche à base de fibres de carbone/substrat carboné/couche à base de fibres de carbone/tapis de TNC) est représentée schématiquement en figure 4.

### 3.2. Performances des PEMFC intégrant les structures multicouches

Les deux structures multicouches obtenues selon l'exemple 3.1. sont mises en oeuvre comme couches de diffusion au niveau de la cathode d'une pile à combustible à membrane échangeuse de protons conventionnelle, en remplacement de la couche microporeuse (MPL), le tapis ou l'un des tapis de NTC étant positionné à l'interface avec la couche active. La couche active de la cathode est à base de platine à 0,4 mg/cm².

L'anode est constituée d'une couche de diffusion commercialisée par la société SGL sous la référence Sigracet 24BC. Elle est composée d'un papier de carbone imprégné à 10 % en poids de PTFE recouvert d'une couche microporeuse à base de PTFE et de noir de carbone. La couche active de l'anode est à base de platine à 0,1 mg/cm².

### Les électrodes sont déposées sur la membrane d'épaisseur de 18 µm.

Les courbes puissance-tension, représentatives des performances des PEMFC obtenues avec chacune des structures multicouches (A) et (B) (conditionnement et performances à 80°C ; 1,5 bars ; H₂/air, 50 % HR de chaque côté) sont représentées en figure 9.

A titre de comparaison, sont représentées les performances obtenues à l'aide d'une PEMFC conventionnelle (C), intégrant une couche de diffusion de nature microporeuse, commercialisée sous la référence Sigracet 24BC par la société SGL. Elle est composée de papier carbone imprégné à 10 % en poids de PTFE recouvert d'une couche microporeuse à base de PTFE et de noir de carbone.

Les performances obtenues en mettant en oeuvre une couche de diffusion selon l'invention, suivant l'une ou l'autre des variantes décrites ci-dessus, sont significativement améliorées pour des densités de courant supérieures à 1 A/cm2.

### Références

[1] Cho et al., Phys. Chem. Chem. Phys. 14, 2012, 4296-4302 ;
[2] Atiyeh et al., Journal of Power Sources 170 (2007), 111-121;
[3] Tang et al., Electrochimica Acta 56 (2011), 4327-4334;
[4] Xie et al., international Journal of Hydrogen Energy 40 (2015), 8958-8965;
[5] "Carbon Nanotubes - Synthesis, Characterization, Applications" Edited by Dr. Siva Yellampalli July 20, 2011;
[6] Liu et al., Journal of Power Sources 220 (2012) 348e353.

## Revendications

1. Structure multicouche (10), utile comme couche de diffusion composite dans une pile à combustible à membrane échangeuse de protons, comportant au moins un tapis de nanotubes de carbone (NTC) (1) de diamètre unitaire inférieur ou égal à 20 nm, définissant au moins une face de ladite structure, ledit tapis de nanotubes de carbone (1) étant superposé à un support à base de fibres de carbone.

2. Structure multicouche selon la revendication 1, dans laquelle l'interface entre le support à base de fibres de carbone et le tapis de nanotubes de carbone qui lui est superposé comprend, voire est formée, d'un empilement de couches minces comportant, dans cet ordre, depuis le support jusqu'au tapis de nanotubes :
a/ éventuellement, une couche métallique en métal M ou couche en alliage métalliques à base du métal M ou couche en graphène, de préférence en fer (Fe) ;
b/ une couche de titane (Ti) ;
c/ une couche d'aluminium (Al) ;
d/ une couche de matériau(x) catalyseur(s) de la croissance de nanotubes de carbone, de préférence en fer (Fe).

3. Structure multicouche selon l'une quelconque des revendications précédentes, dans laquelle le tapis de NTC présente une densité supérieure ou égale à 10¹¹ NTC par cm², de préférence comprise entre 10¹¹ et 10¹³ NTC par cm² et/ou une épaisseur comprise entre 1 et 200 µm, en particulier entre 5 et 100 µm, notamment entre 5 et 50 µm et plus particulièrement entre 10 et 20 µm.

4. Structure multicouche selon l'une quelconque des revendications précédentes, dans laquelle le support à base de fibres de carbone est imprégné sur tout ou partie de son volume par au moins un agent hydrophobe, et/ou dans laquelle la face du substrat, opposée à celle supportant ledit tapis de NTC, est hydrophobe ou recouverte d'un film incorporant au moins un agent hydrophobe.

5. Structure multicouche selon l'une quelconque des revendications précédentes, dans laquelle le support à base de fibres de carbone est imprégné sur tout ou partie de son volume par au moins un agent hydrophobe, et/ou présente sur sa face opposée à celle supportant ledit tapis de NTC, un film.

6. Structure multicouche selon la revendication 4 ou 5, dans laquelle ledit agent hydrophobe est choisi les polymères fluorés et perfluorés, en particulier choisis parmi le poly(fluorure de vinylidène) (PVDF), polytétrafluoroéthylène (PTFE), Éthylène propylène fluoré (FEP) poly(vinylidene fluoride-co-hexafluoropropylene) (PVDF-HFP), poly(éthylène-co-tétrafluoroéthylène) (ETFE) ou perfluoroalkoxy (PFA).

7. Structure multicouche selon l'une quelconque des revendications précédentes, comprenant deux tapis de NTC définissant deux faces opposées de ladite structure.

8. Structure multicouche selon l'une quelconque des revendications précédentes, dans laquelle le support à base de fibres de carbone comprend :
- un substrat (3) à base de fibres de carbone, de préférence hydrophobe, en particulier imprégné par au moins un agent hydrophobe, ledit substrat présentant de préférence entre 2 et 40 % en poids, en particulier entre 5 et 15 % en poids d'agent(s) hydrophobe(s) par rapport à son poids total ; et
- une couche (2) à base de fibres de carbone portée par au moins l'une des faces dudit substrat, comprenant moins de 30 % massique en agent hydrophobe, en particulier moins de 10 % en poids en agent hydrophobe, de préférence étant dépourvue d'agent hydrophobe ;
ladite couche présentant, sur au moins sa face opposée audit substrat, ledit tapis de nanotubes de carbone.

9. Structure multicouche selon l'une quelconque des revendications 1 à 7, dans laquelle le support à base de fibres de carbone est formé d'un substrat (4) massif à base de fibres de carbone, ledit substrat présentant sur l'une de ses faces ledit tapis de nanotubes de carbone.

10. Structure multicouche selon la revendication 9, dans laquelle ledit substrat (4) est imprégné au niveau de sa face opposée à celle supportant le tapis de NTC, par au moins un agent hydrophobe et/ou dans laquelle la face du substrat, opposée au tapis de NTC, est hydrophobe ou recouverte d'un film comportant, voire étant formé d'au moins un agent hydrophobe.

11. Structure multicouche selon la revendication 10, dans laquelle le substrat est imprégné sur une épaisseur, e, s'étendant depuis sa face opposée à celle supportant le tapis de NTC, strictement inférieure à l'épaisseur totale du substrat, en particulier sur une épaisseur e représentant moins de 95 % de l'épaisseur totale du substrat, en particulier moins de 90 %, plus particulièrement moins de 80 % et notamment moins de 60 % de l'épaisseur totale du substrat.

12. Procédé de préparation d'une structure multicouche, utile comme couche de diffusion composite dans une pile à combustible à membrane échangeuse de protons (PEMFC), comprenant au moins les étapes suivantes :
(i) réalisation sur au moins l'une des faces d'un support à base de fibres de carbone, comprenant moins de 30 % massique d'agent hydrophobe, en particulier moins de 10 % en poids d'agent hydrophobe, de préférence dépourvu d'agent hydrophobe, d'un empilement catalytique de couches minces, comprenant dans cet ordre :
a/ éventuellement, une couche métallique en métal M ou couche en alliage métalliques à base du métal M ou couche en graphène ;
b/ une couche de titane (Ti) ;
c/ une couche d'aluminium (Al) ;
d/ une couche de matériau(x) catalyseur(s) de la croissance de nanotubes de carbone ; et
(ii) croissance d'un tapis de nanotubes de carbone sur l'empilement selon une technique de dépôt chimique en phase vapeur, assistée ou non par plasma, et activée par filaments chauds ou non.

13. Procédé selon la revendication précédente, dans lequel ledit support à base de fibres de carbone est, préalablement à sa mise en oeuvre en étape (i), soumis à un traitement thermique, à une température comprise entre 500 et 700 °C, sous atmosphère de gaz inerte(s), d'air, de dihydrogène, de dioxygène, ou un mélange de ces gaz, en particulier un mélange de gaz inerte(s) et de dihydrogène.

14. Procédé selon la revendication 12 ou 13, pour la préparation d'une structure multicouche telle que définie selon la revendication 8, comprenant au moins les étapes suivantes :
(al) réalisation, selon les étapes (i) et (ii), d'un tapis de NTC sur au moins une des faces d'un support à base de fibres de carbone, comportant moins de 30 % massique d'agent(s) hydrophobe(s), de préférence étant dépourvu en agent hydrophobe ; et
(a2) dépôt d'un support préparé selon l'étape (al) sur au moins l'une des faces d'un substrat à base de fibres de carbone, ayant préalablement subi un traitement hydrophobe, de préférence préalablement imprégné par au moins un agent hydrophobe, au moins un tapis de NTC étant présent sur la face du support opposée audit substrat.

15. Procédé selon la revendication 12 ou 13, pour la préparation d'une structure multicouche telle que définie selon l'une quelconque des revendications 9 à 11, comprenant au moins les étapes suivantes :
(b1) réalisation, selon les étapes (i) et (ii), d'un tapis de NTC sur au moins une des faces d'un substrat à base de fibres de carbone, comportant moins de 30 % massique d'agent hydrophobe, de préférence étant dépourvu en agent hydrophobe ;
et, dans le cas de la formation d'un tapis de NTC sur une unique face dudit substrat, éventuellement,
(b2) traitement hydrophobe du substrat au niveau de la face opposée à celle supportant le tapis de NTC, en particulier par imprégnation du substrat, au niveau de la face opposée à celle supportant le tapis de NTC, par au moins un agent hydrophobe, formation sur la face opposée à celle supportant le tapis de NTC, d'un film comportant, voire étant formé, d'au moins un agent hydrophobe, et/ou par traitement plasma avec au moins un gaz fluoré, ledit traitement hydrophobe étant opéré dans des conditions ajustées de manière de pas affecter la structure du tapis de NTC formé en étape (b1).

16. Utilisation d'une structure multicouche telle que définie selon l'une quelconque des revendications 1 à 11 ou obtenue selon le procédé de l'une quelconque des revendications 12 à 15, pour former une couche de diffusion composite dans une électrode, en particulier de la cathode, d'une pile à combustible à membrane échangeuse de protons (PEMFC), au moins un tapis de NTC de ladite structure étant positionné en contact avec la couche active de l'électrode.

17. Electrode, en particulier cathode, pour une pile à combustible à membrane échangeuse de protons, comportant une structure multicouche telle que définie selon l'une quelconque des revendications 1 à 11 ou obtenue selon le procédé de l'une quelconque des revendications 12 à 15, au moins un tapis de NTC de ladite structure étant positionné en contact avec la couche active de l'électrode.

18. Pile à combustible à membrane échangeuse de protons comprenant au moins une électrode telle que définie en revendication 17.
